# EUROPEAN PATENT APPLICATION

(11) **EP 4 089 746 A1**
(43) Date of publication of application: **16.11.2022**
(21) Application number: 21173405.8
(22) Date of filing: 11.05.2021
(51) Int. Cl.: H01L 33/38, H01L 33/46, H01L 33/44

(54) **VERTICAL LIGHT-EMITTING DIODE STRUCTURE WITH METAL LAYER CAPABLE OF TESTING AND PROTECTING SIDEWALLS**

(71) Applicant: Excellence Opto. Inc., Miaoli County 35053 (TW)
(72) Inventor: CHEN, Fu-Bang, 35053 Miaoli County (TW); YEN, Wei-Yu, TAICHUNG CITY (TW); TSAI, Tzeng-Guang, 35053 Miaoli County (TW); CHANG, Chih-Sung, 407 TAICHUNG CITY (TW); HUANG, Kuo-Hsin, 35053 Miaoli County (TW)
(74) Representative: 2K Patentanwälte Blasberg Kewitz & Reichel

(57) **Abstract**

A vertical light-emitting diode structure with a metal layer capable of testing and protecting sidewalls comprises a light-emitting diode element (10), a sidewall passivation layer (40), a welding electrode (50) and a metal protective layer (60), which mainly allows the metal protective layer (60) to be electrically connected to the welding electrode (50), and the metal protective layer (60) covers and protects a chip side edge (302) and a carrier board side edge (201) of the light-emitting diode element (10) with the sidewall passivation layer (40) in between. Accordingly, through coating and protection of the metal protective layer (60), the problem of potential failure of the sidewall passivation layer (40) of the light-emitting diode element (10) during electroplating, electroless plating process or other environmentally rigorous processes can be solved, and the metal protective layer (60) can provide test contacts, a quality of the sidewall passivation layer (40) is evaluated by detecting forward bias (Vf) and reverse leakage current (Ir) of the light-emitting diode element (10).

## Description

### FIELD OF THE INVENTION

The invention relates to a vertical light-emitting diode structure, and more particularly to a vertical light-emitting diode structure with a metal layer capable of testing and protecting sidewalls.

### BACKGROUND OF THE INVENTION

In the conventional vertical light-emitting diode, the chip structure includes an N-type semiconductor layer, a light-emitting layer, and a P-type semiconductor layer forming a sandwich structure. A mirror layer, a buffer layer, a bonding layer, a silicon substrate, and a P-type electrode are sequentially disposed under the P-type semiconductor layer. A surface of the N-type semiconductor layer can be roughened to increase light emergent rate, and provided for disposing an N-type electrode. Accordingly, after applying voltage to the N-type electrode and the P-type electrode, the N-type semiconductor layer provides electrons, and the P-type semiconductor layer provides electron holes. The electrons and the electron holes are combined in the light-emitting layer to generate light.

When water vapor is attached or conductive substances are adhered on sides of P-N junction of the chip of the vertical light-emitting diode, it may cause the element to fail after being electrified. Therefore, the vertical light-emitting diode generally has a sidewall passivation layer, the sidewall passivation layer is usually made of SiO₂ with a thickness in a range from 0.1 micron (µm) to 1 micron (µm) to protect the P-N junctions of the chip to prevent potential water vapor from attaching and conductive substances from adhering.

A coating quality of the sidewall passivation layer of the vertical light-emitting diode is difficult to control and confirm, and micro-cracks often appear. However, under poor process conditions, even if the thickness is increased, the quality will not be improved, but will cause block peeling. In the conventional vertical light-emitting diode, since the subsequent packaging process mostly uses chip bonding and wire bonding processes, it does not have much impact. When the vertical light-emitting diode completes the packaging process, the chip of the vertical light-emitting diode has been better protected, and the quality of coating of the sidewall passivation layer has almost no effect.

However, when the subsequent packaging process involves rigorous processes such as electroplating or electroless plating, if the chip protected by the sidewall passivation layer with defect is placed in the electroplating or electroless plating process, metal ions in the electrolyte will enter through the micro-cracks and adhere on the P-N junctions, which will cause the vertical light-emitting diode to fail during the subsequent manufacturing process. At the same time, reliability is reduced that will cause a huge increase in costs and product risk.

### SUMMARY OF THE INVENTION

It is an object of the present invention to provide a vertical light-emitting diode structure that can be produced and operated reliably and in a simple manner.

This problem is solved by a light-emitting diode structure with a metal layer capable of testing and protecting sidewalls as claimed in claim 1. Further advantageous embodiments are the subject-matter of the dependent claims.

According to the present invention there is provided a light-emitting diode structure covered by a metal layer. The metal layer can be used to detect compactness and quality of an outer passivation layer of four sides of P-N junction of a chip of the vertical light-emitting diode structure. At the same time, this stable metal layer also has an efficacy of preventing potential water vapor from attaching and conductive substances from adhering to the P-N junctions in subsequent processes.

The invention is a vertical light-emitting diode structure with a metal layer capable of testing and protecting sidewalls comprising a light-emitting diode element, a sidewall passivation layer, a welding electrode and a metal protective layer, wherein the light-emitting diode element includes a conductive carrier board and a light-emitting diode chip, and the light-emitting diode chip is formed on the conductive carrier board. The light-emitting diode chip includes a chip upper edge and a chip side edge, and the chip side edge is connected to the chip upper edge and surrounds the light-emitting diode chip.

The conductive carrier board includes a carrier board side edge and a carrier board upper edge, the carrier board side edge is connected to the chip side edge, the carrier board upper edge is connected to the carrier board side edge, and the light-emitting diode chip is not above the carrier board upper edge. The sidewall passivation layer covers the chip upper edge, the chip side edge and the carrier board side edge, the sidewall passivation layer includes a first electrode exposing area at the chip upper edge, and the first electrode exposing area exposes the light-emitting diode chip.

The welding electrode passes through the first electrode exposing area to be electrically connected to the light-emitting diode chip. The metal protective layer is electrically connected to the welding electrode, and the metal protective layer covers and protects the chip side edge and the carrier board side edge with the sidewall passivation layer in between.

Accordingly, through the metal protective layer covers the chip upper edge, the chip side edge and the carrier board side edge, the present invention prevents water vapor and conductive substances from adhering to the P-N junctions of the light-emitting diode element.

In addition, a fine and compact coating layer of the metal protective layer forms a good barrier layer capable of solving the potential problem of sidewall passivation layer failure of the light-emitting diode element during electroplating or electroless plating processes or other environmentally rigorous processes.

Further, the metal protective layer can provide test contacts, and a quality of the sidewall passivation layer can be evaluated by detecting forward bias (Vf) and reverse leakage current (Ir) of the light-emitting diode element.

In more detail, the metal protective layer is applied to an outside of the sidewall passivation layer, and applied by depositing a metal film (such as metal evaporation, metal sputtering, etc.). If there are cracks and defects in the sidewall passivation layer on outer sides of the P-N junctions, deposited metal will penetrate into the P-N junction sides when the metal protective layer is subsequently applied. At this time, it will cause the element to leak or conduct current. The defective element can be detected by detecting an electrical property of the light-emitting diode (LED) chip, and the element with poor sidewall passivation layer can be eliminated in the chip segment. At the same time, a metal with better stability can be selected as the metal protective layer to make the P-N junction sides of the LED chip more stable in subsequent manufacturing processes.

### BRIEF DESCRIPTION OF THE DRAWINGS

FIG. 1 is a cross-sectional structural view of a first embodiment of the invention;
FIG. 2 is a cross-sectional structural view of subsequent processes of the first embodiment of the invention;
FIG. 3 is a cross-sectional structural view of a second embodiment of the invention; and
FIG. 4 is a cross-sectional structural view of a third embodiment of the invention.

### DETAILED DESCRIPTION OF THE PREFERRED EMBODIMENTS

In order to enable the examiner to have a deeper understanding and recognition of the features, objects and efficacies of the invention, three preferred embodiment are provided below in conjunction with the accompanying drawings.

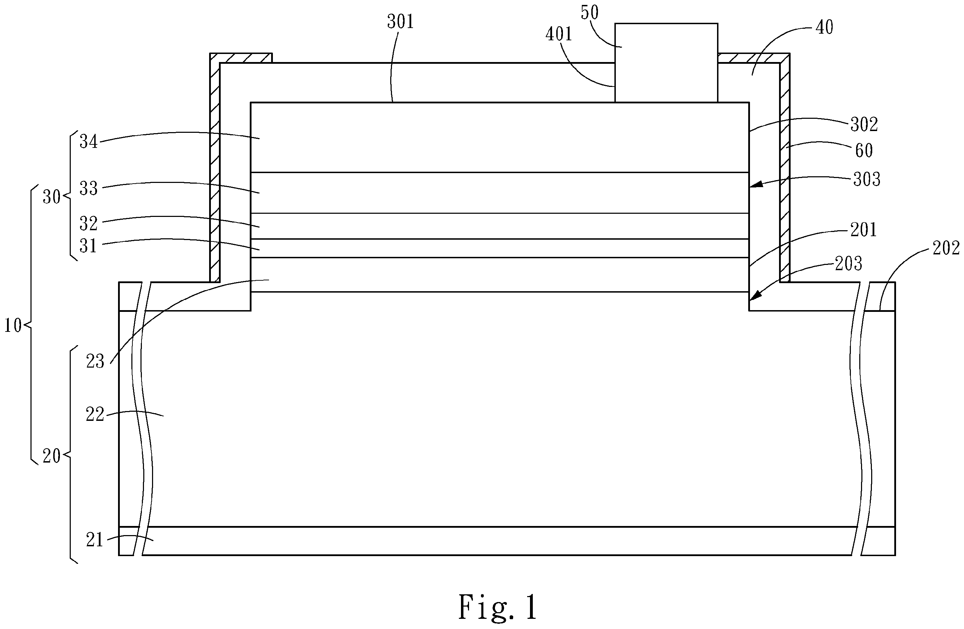

Please refer to FIG. 1 for a cross-sectional structural view of a first embodiment of the invention. The invention provides a vertical light-emitting diode structure with a metal layer capable of testing and protecting sidewalls comprising a light-emitting diode element 10, a sidewall passivation layer 40, a welding electrode 50 and a metal protective layer 60.

The light-emitting diode element 10 includes a conductive carrier board 20 and a light-emitting diode chip 30, and the light-emitting diode chip 30 is formed on the conductive carrier board 20. The light-emitting diode chip 30 includes a chip upper edge 301 and a chip side edge 302, and the chip side edge 302 is connected to the chip upper edge 301 and surrounds the light-emitting diode chip 30. The conductive carrier board 20 includes a carrier board side edge 201 and a carrier board upper edge 202. The carrier board side edge 201 is connected to the chip side edge 302, and the carrier board upper edge 202 is connected to the carrier board side edge 201 The light-emitting diode chip 30 is not located above the carrier board upper edge 202.

The sidewall passivation layer 40 covers the chip upper edge 301, the chip side edge 302 and the carrier board side edge 201. The sidewall passivation layer 40 includes a first electrode exposing area 401 at the chip upper edge 301, and the first electrode exposing area 401 exposes the light-emitting diode chip 30. A thickness of the sidewall passivation layer 40 is about 0.5 micron (µm).

The welding electrode 50 passes through the first electrode exposing area 401 to be electrically connected to the light-emitting diode chip 30. In one embodiment, the light-emitting diode chip 30 includes a first metal contact layer 31, a first electrical semiconductor layer 32, an active layer 33, and a second electrical semiconductor layer 34 stacked in sequence. A thickness of the light-emitting diode chip 30 is about 3 microns (µm). The welding electrode 50 is electrically connected on the second electrical semiconductor layer 34. The conductive carrier board 20 includes a metal electrode 21, a conductive block 22 and a metal connection layer 23 stacked in sequence, and the first metal contact layer 31 is formed on the metal connection layer 23.

The metal protective layer 60 is electrically connected with the welding electrode 50, the metal protective layer 60 covers and protects the chip side edge 302 and the carrier board side edge 201 with the sidewall passivation layer 40 in between, and in order to clearly show the metal protective layer 60, only a section line of the metal protective layer 60 is drawn. In actual implementation, a material of the sidewall passivation layer 40 is selected from a group consisting of SiO₂, SiN, SiN/SiO₂/SiN, TiO₂ and TiO₂/SiO₂/TiO₂, and a material of the metal protective layer 60 is selected from a group consisting of Pt, TiW, Cr, Pt, Au, CuW, Cr/Au, Al/Cr/Au, Ti/Au, Ge/Ni/Au, Be/Au and Ni/Au. Preferably, a thickness of the metal protective layer 60 is in a range from 0.05 micron (µm) to 3 microns (µm). More preferably, a thickness of the metal protective layer 60 is 1.5 microns (µm).

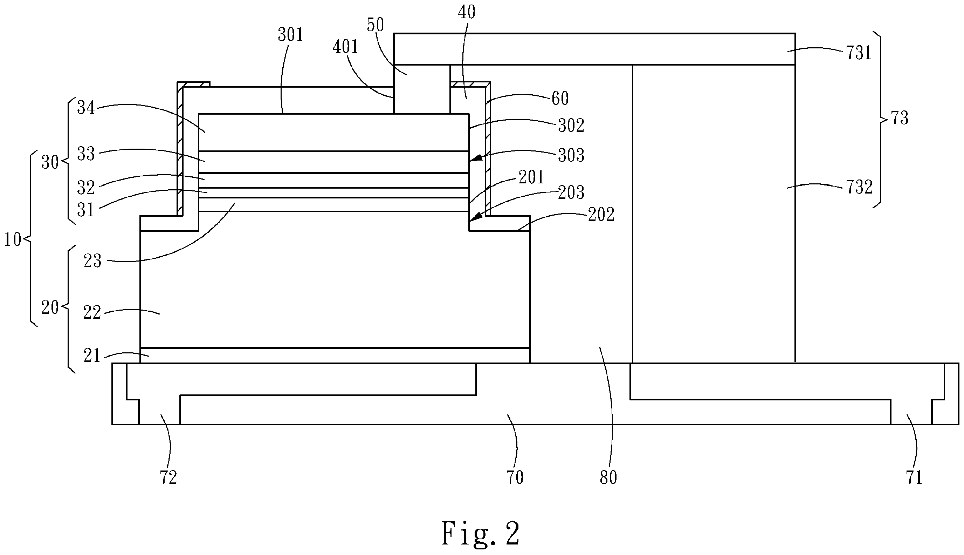

Please refer to FIG. 2 for a cross-sectional structural view of subsequent processes of the first embodiment of the invention. The conductive carrier board 20 is formed on a substrate 70. The substrate 70 includes a first electrode bonding pad 71 and a second electrode bonding pad 72. The second electrode bonding pad 72 is electrically connected to the conductive carrier board 20. The first electrode bonding pad 71 is electrically connected to the welding electrode 50. In implementation, the first electrode bonding pad 71 is electrically connected to the welding electrode 50 through a metal connection block 73. The metal connection block 73 includes a horizontal portion 731 and a vertical portion 732. The horizontal portion 731 is electrically connected to the welding electrode 50, and the vertical portion 732 is electrically connected to the first electrode bonding pad 71. In addition, there can be a filling portion 80 between the vertical portion 732 and the metal protective layer 60.

As shown in the embodiment in FIG. 2, the metal connection block 73 can be made by electroplating or electroless plating process, which replaces the traditional wire bonding process and is more suitable for mass production. In electroplating or electroless plating process, regardless of whether the sidewall passivation layer 40 has defects (cracks), the metal protective layer 60 can be used to exert an effect of blocking water vapor and conductive substances (metal ions). Further, before performing electroplating or electroless plating process, the metal protective layer 60 can be used as a test contact to detect forward bias (Vf), reverse leakage current (Ir) and other circuit properties of the light-emitting diode element 10, a quality of the sidewall passivation layer 40 can be evaluated by measured values, and defective products can be eliminated to improve a yield of subsequent processes.

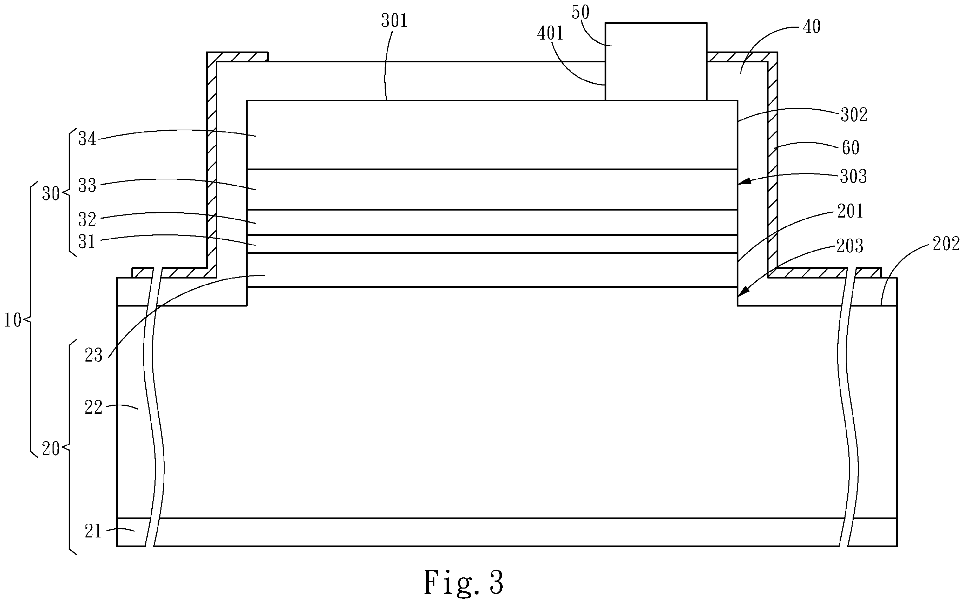

Please refer to FIG. 3 for a cross-sectional structural view of a second embodiment of the invention. The sidewall passivation layer 40 covers the carrier board upper edge 202, and the metal protective layer 60 covers the carrier board upper edge 202 with the sidewall passivation layer 40 in between. In one embodiment, a width of the carrier board upper edge 202 is in a range from 10 microns (µm) to 50 microns (µm), and a width of an outer side of the carrier board upper edge 202 without the metal protective layer 60 is at least 5 microns (µm).

As shown in the first embodiment and the second embodiment in FIG. 1 and FIG. 3, the conductive carrier board 20 and the light-emitting diode chip 30 can be rectangular, so that the chip side edge 302 and the carrier board side edge 201 include four chip side surfaces 203 and four carrier board side surfaces 303 respectively, and the metal protective layer 60 covers and protects the four chip side surfaces 203 and the four carrier board side surfaces 303 in order to achieve a proper protection effect.

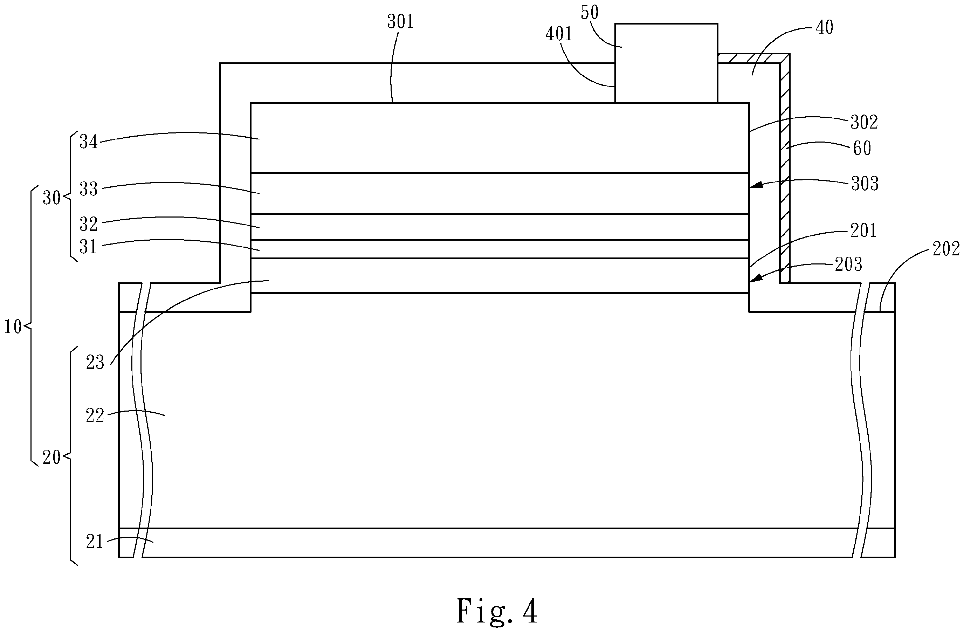

Please refer to FIG. 4 for a third embodiment of the invention. In order to reduce manufacturing cost, the metal protective layer 60 only covers and protects one chip side surface 203 and one carrier board side surface 303 closest to the welding electrode 50, because in electroplating or electroless plating process, the chip side surface 203 and the carrier board side surface 303 closest to the welding electrode 50 are most likely to be adhered with water vapor and conductive substances (metal ions). Therefore, the manufacturing cost is saved by only coating the metal protective layer 60 on the chip side surface 203 and the carrier board side surface 303 closest to the welding electrode 50.

As mentioned above, characteristics of the invention at least include:
1. Through covering of the metal protective layer, an effect of blocking water vapor and conductive substances (metal ions) can be exerted, which has an efficacy of strengthening and dual-protecting the sidewall passivation layer.
2. The metal protective layer can be used as a test contact to detect forward bias (Vf), reverse leakage current (Ir) and etc. of the light-emitting diode element, and a quality of the sidewall passivation layer can be evaluated by measured values.
3. The metal protective layer can be partially covered on one of the chip side surfaces and one of the carrier board side surfaces closest to the welding electrode to save manufacturing costs.

## Claims

1. A vertical light-emitting diode structure with a metal layer capable of testing and protecting sidewalls, comprising:
a light-emitting diode element (10), comprising a conductive carrier board (20) and a light-emitting diode chip (30) formed on the conductive carrier board (20), the light-emitting diode chip (30) comprising a chip upper edge (301) and a chip side edge (302) connected to the chip upper edge (301) and surrounding the light-emitting diode chip (30), the conductive carrier board (20) comprising a carrier board side edge (201) connected to the chip side edge (302), and a carrier board upper edge (202) connected to the carrier board side edge (201), and the light-emitting diode chip (30) not being located above the carrier board upper edge (202);
a sidewall passivation layer (40), covering the chip upper edge (301), the chip side edge (302) and the carrier board side edge (201), said sidewall passivation layer (40) comprising a first electrode exposing area (401) at the chip upper edge (301), and the first electrode exposing area (401) exposing the light-emitting diode chip (30);
a welding electrode (50), passing through the first electrode exposing area (401) to be electrically connected to the light-emitting diode chip (30); and
a metal protective layer (60), electrically connected to the welding electrode (50), wherein the metal protective layer (60) covers and protects the chip side edge (302) and the carrier board side edge (201) with the sidewall passivation layer (40) in between.

2. The vertical light-emitting diode structure as claimed in claim 1, wherein the light-emitting diode chip (30) comprises a first metal contact layer (31), a first electrical semiconductor layer (32), an active layer (33), and a second electrical semiconductor layer (34) stacked in sequence, and wherein the welding electrode (50) is electrically connected on the second electrical semiconductor layer (34).

3. The vertical light-emitting diode structure as claimed in claim 2, wherein the conductive carrier board (20) includes a metal electrode (21), a conductive block (22) and a metal connection layer (23) stacked in sequence, and the first metal contact layer (31) is formed on the metal connection layer (23).

4. The vertical light-emitting diode structure as claimed in any of the preceding claims, wherein the sidewall passivation layer (40) covers the carrier board upper edge (202), and the metal protective layer (60) covers the carrier board upper edge (202) with the sidewall passivation layer (40) in between.

5. The vertical light-emitting diode structure with the metal layer capable of testing and protecting sidewalls as claimed in claim 4, wherein a width of the carrier board upper edge (202) is in a range from 10 microns (µm) to 50 microns (µm), and a width of an outer side of the carrier board upper edge (202) without the metal protective layer (60) is at least 5 microns (µm).

6. The vertical light-emitting diode structure as claimed in any of the preceding claims, wherein a material of the sidewall passivation layer (40) is selected from a group consisting of SiO₂, SiN, SiN/SiO₂/SiN, TiO₂ and TiO₂/SiO₂/TiO₂, and a material of the metal protective layer (60) is selected from a group consisting of Pt, TiW, Cr, Pt, Au, CuW, Cr/Au, Al/Cr/Au, Ti/Au, Ge/Ni/Au, Be/Au and Ni/Au.

7. The vertical light-emitting diode structure as claimed in any of the preceding claims, wherein a thickness of the metal protective layer (60) is in a range from 0.05 micron (µm) to 3 microns (µm).

8. The vertical light-emitting diode structure as claimed in claim 7, wherein a thickness of the metal protective layer (60) is 1.5 microns (µm).

9. The vertical light-emitting diode structure as claimed in any of the preceding claims, wherein the conductive carrier board (20) and the light-emitting diode chip (30) are rectangular, the chip side edge (302) and the carrier board side edge (201) comprise four chip side surfaces (203) and four carrier board side surfaces (303) respectively, and the metal protective layer (60) covers and protects the four chip side surfaces (203) and the four carrier board side surfaces (303).

10. The vertical light-emitting diode structure as claimed in any of the preceding claims, wherein the conductive carrier board (20) and the light-emitting diode chip (30) are rectangular, the chip side edge (302) and the carrier board side edge (201) comprise four chip side surfaces (203) and four carrier board side surfaces (303) respectively, and the metal protective layer (60) covers and protects one of the four chip side surfaces (203) and one of the four carrier board side surfaces (303) closest to the welding electrode (50).
